**Europäisches Patentamt**

**European Patent Office**

**Office européen des brevets**

(19)

(11), Veröffentlichungsnummer: **0 035 103**
**B1**

# EUROPÄISCHE PATENTSCHRIFT

(12)

(45) Veröffentlichungstag der Patentschrift:
**11.07.84**

(21) Anmeldenummer: **81100271.6**

(22) Anmeldetag: **15.01.81**

(51) Int. Cl.³: **H 01 L 29/04**, H 01 L 43/06,
H 01 L 27/22

(54) **Monolithisch integrierte Anordnung zweier Hallsonden.**

(30) Priorität: **18.01.80 DE 3001772**

(43) Veröffentlichungstag der Anmeldung:
**09.09.81 Patentblatt 81/36**

(45) Bekanntmachung des Hinweises auf die Patenterteilung:
**11.07.84 Patentblatt 84/28**

(84) Benannte Vertragsstaaten:
**FR GB IT**

(56) Entgegenhaltungen:
**DE - A - 2 009 102**
**DE - A - 2 804 373**
**GB - A - 2 000 639**
**US - A - 3 823 354**

**IBM TECHNICAL DISCLOSURE BULLETIN, Band 22, Nr. 9, Februar 1980, NEW YORK (US) S.S. HEGEDUS: "Piezoresistive Stress Independent Hall Device", Seiten 4006-4008**

(73) Patentinhaber: **SIEMENS AKTIENGESELLSCHAFT, Berlin und München Wittelsbacherplatz 2, D-8000 München 2 (DE)**

(72) Erfinder: **von Häfen, Günter Dr. Dipl.-Phys., Josef-Mohr-Weg 57, D-8000 München 83 (DE)**
Erfinder: **Roloff, Herbert F. Dr. Dipl.-Phys., Akademiestrasse 21, D-8000 München 40 (DE)**

## Beschreibung

Die Erfindung betrifft eine monolithisch integrierte Anordnung zweier Hallsonden gemäss der Präambel des Patentanspruchs 1.

Piezoeffekte sind bei bestimmten Anwendungen von Halbleiterbauelementen nicht erwünscht. Beispielsweise können die Werte von Widerständen in integrierten Schaltungen durch Piezoeffekte verfälscht werden (siehe z.B. GB-A-2 000 639).

Auch bei Hallelementen, die z.B. als integrierte Schaltungen in Siliciumchips vorliegen, sind Piezoeffekte unerwünscht, da als Folge von mechanischen Verspannungen auch Piezoeffekte Ausgangsspannungen an einem Hallelement hervorrufen können, so dass die durch anliegende Magnetfelder hervorgerufenen Ausgangssignale dadurch verfälscht werden.

Um störende Piezoeffekte auszuschalten, hat man bereits versucht, Halbleiterbauelemente durch spezielle Montagemassnahmen so anzubringen, dass möglichst wenig Kräfte vom Gehäuse auf den Chip übertragen werden. So wurden z.B. Halbleiterchips freischwebend lediglich an Kontaktfingern befestigt oder sie wurden in Klebe- oder Umhüllungsmassen, z.B. bestehend aus weichem Kunststoff, so eingebettet, dass äussere Kräfte durch das Gehäuse nicht auf den Chip übertragen werden. Es wurden auch Chips ohne Metallträger frei in Plastikgehäuse eingebettet. Alle diese Massnahmen erfordern einen hohen Aufwand und lassen im allgemeinen keine Automation entsprechender Herstellungsverfahren zu. Zur Massenherstellung von Halbleiterbauelementen sind diese Verfahren deshalb nicht geeignet.

Aus der DE-AS-2 518 478 ist es bekannt, Hallelemente aus Silicium-Einkristallen so herzustellen, dass die Oberfläche des Hallbereichs parallel zur (110)-Netzebene und senkrecht zum aufgeprägten Magnetfluss verläuft. Ein so ausgebildetes Hallelement weist im allgemeinen bei Einwirkung innerer oder äusserer mechanischer Spannungen eine wesentlich geringere Spannungsunsymmetrie auf als entsprechende Silicium-Hallelemente, bei denen eine andere Kristallorientierung gewählt ist.

Piezoeffekte lassen sich dadurch verringern, jedoch nicht kompensieren.

Da eine völlige Kompensation von Piezoeffekten nach der genannten Auslegeschrift nicht möglich ist, ist es im allgemeinen erforderlich, ein nach der genannten Auslegeschrift hergestelltes Hallelement durch zusätzliche spezielle Montagemassnahmen, z.B. wie sie eingangs erwähnt wurden, vor mechanischen Verspannungen zu schützen.

Die Herstellung von Silicium-Substraten, deren Oberfläche parallel zu der (110)-Netzebene verläuft, ist nur mit zusätzlichem Aufwand zu erreichen. Wünschenswert wäre es vielmehr, zur Herstellung von Halbleiterbauelementen mit kompensierten Piezoeffekten, Standard-Halbleitermaterialien, wie z.B. Silicium-Substrate, zu verwenden, deren Oberfläche parallel zur (110)-Netzebene verläuft.

Beide der genannten Massnahmen, sowohl eine spezielle Montage als auch die Herstellung von Silicium-Substraten mit einer (110)-Ebene parallel zur Substratoberfläche, erfordern einen hohen Arbeitsaufwand und eignen sich im allgemeinen nicht zur Automatisierung entsprechender Herstellungsverfahren. Sie sind deshalb für die Herstellung entsprechender Bauelemente von geringer Bedeutung.

Aus der US-PS-3 823 354 ist es bekannt, bei Hallelementen, bestehend aus einen einkristallinen Halbleitersubstrat mit eingeprägter integrierter Schaltung, zwei oder mehr Halbleiterbereiche so mit Stromanschlüssen zu bestücken, dass die Stromrichtung der einzelnen Bereiche Winkel zueinander bilden, wodurch unter anderem auch eine Kompensation von Piezoeffekten bewirkt wird. Über die Netzebenenrichtung hierzu verwendeter Halbleitersubstrate wird jedoch keine Aussage gemacht. Da der Piezoeffekt sowie praktisch alle physikalischen Eigenschaften in Kristallen entscheidend von der Kristallrichtung abhängt, kann eine optimale Kompensation von Piezoeffekten nur durch eine geeignete Wahl von Stromrichtungen in gewissen Halbleiterbereichen in Abhängigkeit von der Kristallrichtung erfolgen.

Diese Massnahmen haben den Vorteil, dass sich Piezoeffekte bei Halbleiterbauelementen so stark kompensieren lassen, dass aufwendige Montageverfahren eingespart werden können. Gleichzeitig lassen sich durch diese Massnahmen zugehörige Herstellungsverfahren automatisieren, wodurch eine Massenproduktion hiernach gefertigter Bauelemente ermöglicht wird.

Es ist vorteilhaft, dass auf dem Chip zwei Halbleiterbereiche so mit Anschlusskontakten versehen sind, dass der Stromfluss in den beiden Halbleiterbereichen senkrecht zueinander erfolgt.

Es hat sich gezeigt, dass bei der Verwendung von zwei Halbleiterbereichen und bei einer vorgegebenen Kristallrichtung auftretende Piezoeffekte von Halbleiterbauelementen sich dadurch optimal kompensieren lassen, dass die Stromrichtung innerhalb dieser Halbleiterbereiche senkrecht zueinander verläuft.

Es ist vorteilhaft, dass das einkristalline Halbleiterchip aus Silicium besteht. Da Silicium ein häufig verwendetes Halbleitermaterial ist und somit auch eine Vielzahl von technisch ausgereiften Herstellungs- und Verarbeitungstechnologien bekannt sind, ist die Verwendung dieses Materials im Hinblick auf eine Massenherstellung von entsprechenden Bauelementen besonders geeignet.

Die oben genannte GB-A-2 000 639 beschreibt ausserdem ein Halbleiterbauelement, bei dem Widerstandseinheiten senkrecht zueinander in einem monolithischen Siliciumchip angeordnet sind. Hinsichtlich der Kristallorientierungen ist bei einem derartigen Halbleiterbauelement gemäss Seite 1, Zeilen 48 bis 51 des Dokuments vorgesehen, dass, um störende mechanische Verspannungen auszuschalten, bei p-leitenden Widerstandseinheiten die Hauptfläche unter anderem eine 100-Fläche und bei n-leitenden Widerstandseinheiten eine 111-Fläche ist.

Aufgabe der vorliegenden Erfindung ist es, ein Halbleiterbauelement gemäss der Präambel des Patentanspruchs 1 anzugeben, das eine so weitgehende Kompensation von Piezoeffekten aufweist, dass aufwendige Montagemethoden eingespart und zugehörige Herstellungsverfahren automatisiert werden können. Diese Aufgabe wird erfindungsgemäss dadurch gelöst, dass zur Kompensation von Piezoeffekten das einkristalline Halbleiterchip aus einem Siliciumkristall der Kristallorientierung (100) besteht.

Standardmaterialien, wie sie die einschlägigen Herstellungsverfahren für Silicium liefern, weisen die genannte Kristallrichtung auf, weshalb eine Verwendung derartiger Materialien für die zu fertigenden Halbleiterbauelemente besonders vorteilhaft ist.

Weiterhin ist es vorteilhaft, dass an den Halbleiterbereichen abgegriffene Ausgangssignale vor oder nach einer anschliessenden Signalverstärkung parallel zueinander geschaltet werden. Eine derartige Schaltung verstärkt bei Parallelschaltung nach Signalverstärrkung gleichzeitig das gewünschte Nutzsignal und kompensiert bei geeigneter Wahl von Kristallrichtung und Stromrichtung innerhalb der zugehörigen Halbleiterbereiche auftretende Piezoeffekte optimal.

Es ist auch vorteilhaft, dass einkristalline Halbleitersubstratscheiben, bestehend aus Silicium, mit einer bestimmten (100) Kristallorientierung mit einer p-Dotierung versehen, hergestellt werden, dass mittels Maskierung und Fotolithografie in den Substratscheiben $n^+$-Diffusionen als buried-layer angebracht werden, dass auf den Substratscheiben eine n-dotierte Epitaxieschicht abgeschieden wird, dass mittels Maskierung und Fololithografie p-Diffusionen für Isolationsrahmen angebracht werden, wodurch gleichzeitig die n-Bereiche in dem zu erzeugenden Halbleiterelement definiert werden, dass zur eventuellen Anbringung weiterer Bauelemente auf dem gleichen Halbleitersubstrat mittels weiterer Maskierung und Fotolithografie weitere $p^+$-Diffusionsgebiete gebildet werden, dass mittels erneuter Maskierung und Fotolithografie weitere $n^+$-Diffusionsbereiche, z.B. als Anschlussdiffusionsbereiche für Hallsonden in der Epitaxieschicht erzeugt werden, dass mittels weiterer Maskierung und Fotolithografie Kontaktfenster für Metallanschlüsse geschaffen werden, dass eine Kontaktmetallbedampfung, z.B. Aluminiumbedampfung, erfolgt, dass mittels weiterer Fotolithografie auf der Halbleiteroberfläche Leitbahnen zum Anschluss hiernach gefertigter Bauelemente erzeugt werden.

Nachfolgend wird die Erfindung anhand der Zeichnung und anhand von Ausführungsbeispielen näher erläutert. Es zeigen:

Fig. 1 eine Draufsicht auf zwei senkrecht zueinander angeordnete und parallel geschaltete Hallsonden als integrierte Schaltung in einem Halbleiterchip,

Fig. 2 zwei senkrecht zueinander angeordnete Hallsonden als integrierte Schaltung in einem Halbleiterchip,

Fig. 3 eine perspektivische Darstellung einer längs der Linie III-III geschnittenen Hallsonde nach Fig. 2.

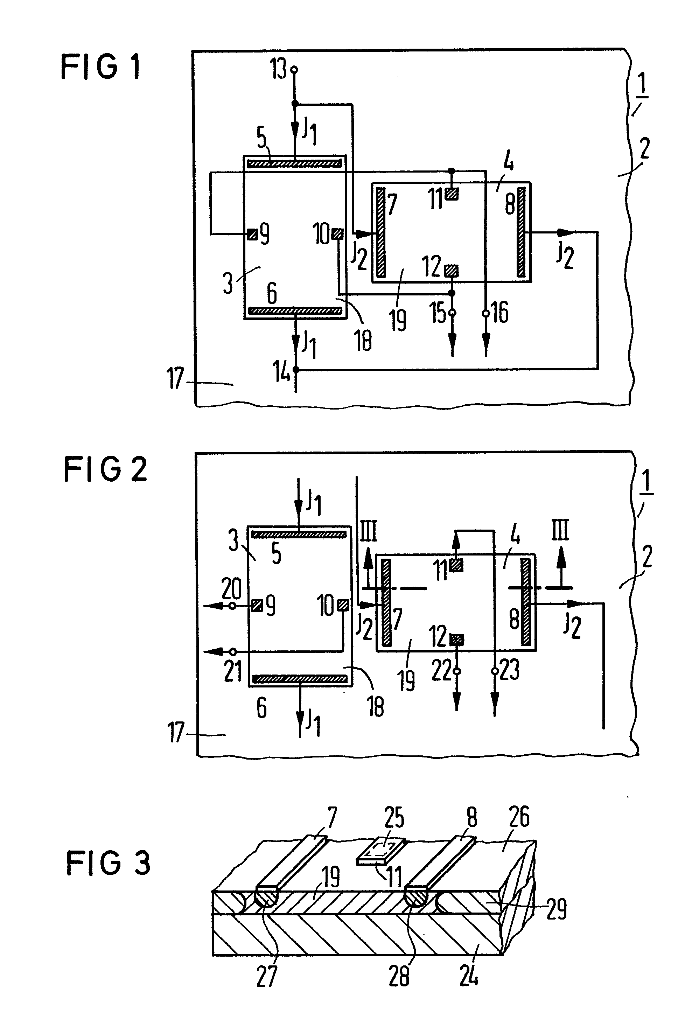

Fig. 1 stellt einen Ausschnitt aus einem erfindungsgemässen Halbleiterbauelement 1 in Draufsicht dar. In einem Halbleiterchip 2 aus einem Siliciumkristall der Kristallorientierung (100) sind eine Hallsonde 3 und eine Hallsonde 4 als integrierte Schaltung senkrecht zueinander angebracht, d.h. so angebracht, dass die Stromrichtunng der Sonde 3, $I_1$ senkrecht zur Stromrichtung $I_2$ der Hallsonde 4 verläuft. Hallsonde 3 und Hallsonde 4 sind parallel geschaltet. Dadurch löschen sich Störsignale, die durch Piezoeffekte erzeugt werden, gerade aus. Die Nutzsignale der beiden Hallsonden 3 und 4 verstärken sich bei dieser Schaltung jedoch nicht. Die Hallsonde 3 weist die Stromanschlüsse 5 und 6 auf, während die Hallsonde 4 die Stromanschlüsse 7 und 8 aufweist. Ausserdem weist die Hallsonde 3 die Spannungsabgriffe 9 und 10 auf, während die Hallsonde 4 die Spannungsabgriffe 11 und 12 aufweist. An die Punkte 13 und 14 wird die Betriebsspannung für die Hallsonden 3 und 4 angelegt, während die Ausgangssignale der Sonden 3 und 4 an den Punkten 15 und 16 abgegriffen werden können. Die Dotierung eines erfindungsgemässen Halbleiterbauelements 1 wird so gewählt, dass der Halbleiterrahmen 17 p-dotiert ist, während die Sondenbereiche 18 und 19 der Hallsonden 3 und 4 n-dotiert sind. Die Halbleiterbereiche unterhalb der Anschlüsse 5, 6, 7 und 8 sowie die Halbleiterbereiche unterhalb der Spannungsabgriffe 9, 10, 11 und 12 sind $n^+$-dotiert.

Fig. 1 stellt nur einen Ausschnitt aus einem Halbleiterchip dar. Ausser den im Ausschnitt dargestellten Hallsonden können sich auf einem solchen Halbleiterchip weitere Schaltungen z.B. zur Spannungsversorgung oder auch Verstärkerschaltungen befinden.

Nach der Lehre der Erfindung können auch mehr als zwei Hallsonden in vorbestimmter gegenseitiger Lage und in vorbestimmter Lage zur Kristallorientierung des Halbleiterchips auf diesem aufgebracht sein. Durch eine geeignete Anbringung einer Vielzahl von Hallsonden auf einem Halbleiterchip lassen sich sowohl Piezostöreffekte in höherem Masse kompensieren als auch weitere Störeffekte, z.B. herrührend von Dotierungsschwankungen, Schichtdickenschwankungen usw., weitgehend kompensieren.

Fig. 2 stellt ebenfalls wie Fig. 1 eine Draufsicht auf einen Ausschnitt eines erfindungsgemässen Halbleiterbauelements 1 dar. Alle mit Fig. 1 identischen Teile sind mit dem gleichen Bezugszeichen belegt und werden nicht nochmals erläutert. Im Gegensatz zu Fig. 1 ist die Hallsonde 3 und die Hallsonde 4 der Fig. 2 nicht parallel geschaltet. Jede der Sonden verfügt vielmehr über getrennte Ausgänge, angedeutet durch die Punkte 20 und 21 der Hallsonde 3 und die Punkte 22 und 23 der Hallsonde 4. Die an den getrennten Ausgängen abgegriffenen Ausgangsspannungen werden getrennt verstärkt, was in der Zeichnung nicht dargestellt ist, und diese verstärkten Signale werden anschliessend elektronisch addiert. Dadurch kann, wie in Fig. 1 beschrieben, eine Auslöschung von piezobedingten Störeffekten, aber zusätzlich auch eine Addition der Hauptsignale erreicht werden. Die strichpunktierte Linie III-III deutet eine Schnittlinie senkrecht zur Zeichenebene an, woraus die perspektivische Darstellung in Fig. 3 resultiert.

In Fig. 3 ist auf einem p-dotierten Halbleitersubstrat 24 eine n-leitende epitaktisch aufgebrachte Halbleiterschicht 29 abgeschieden. In diese Schicht 29 wird ausserhalb des Sondenbereichs 19 eine n-Dotierung angebracht. Die $n^+$-dotierten streifenförmigen Bereiche 27 und 28 unterhalb der Anschlüsse 7 und 8 sowie der n⁺-dotierte Bereich 25, angedeutet durch die strichlierten Linien und unterhalb des Spannungsabgriffs 11 sind zum Zwecke eines guten elektrischen Kontakts zwischen Halbleiter und zugehörigen Anschlüssen angebracht. Das erfindungsgemässe Halbleiterbauelement ist aus Silicium gefertigt. Auf der Halbleiteroberfläche 26 ist ganzflächig mit Ausnahme der Kontaktbereiche eine in der Zeichnung nicht dargestellte Siliciumdioxidschicht zur Isolation und zum Schutze der Halbleiteroberfläche angebracht. Wesentlich für die Erfindung ist die (100)-Kristallorientierung der Halbleiteroberfläche 26 sowie die Ausrichtung der Hallsonden 3 und 4 gegeneinander und bezüglich der Kristallrichtungen innerhalb der Ebene 26. Die (100)-Orientierung der Oberfläche 26 sowie die Anordnung der Hallsonden 3 und 4 hat so zu erfolgen, dass sich die Piezoeffekte innerhalb eines vorgegebenen Bereichs optimal kompensieren. Dabei kann auch eine optimale Kompensation von Piezoeffekten selbst dann erfolgen, wenn die Störeffekte an den einzelnen Sonden nicht minimal sind. Bei der Verwendung von Silicium kann in vorteilhafter Weise die Wahl der Kristallorientierung der Oberfläche 26, dass sie mit der Kristallorientierung (100) identisch ist, eine erhebliche Herstellungsvereinfachung bedeuten, da dieses Material Standardmaterial ist, wie es nach den üblichen Herstellungsverfahren gewonnen wird.

**Patentansprüche**

1. Monolithisch integrierte Anordnung zweier Hallsonden, die an einem gemeinsamen ebenen Oberflächenteil eines dotierten monokristallinen Siliciumplättchens erzeugt sind, bei der jede der beiden Hallsonden durch je einen Halbleiterbereich mit n-Leitertyp sowie jeweils zwei den betreffenden Halbleiterbereich sperrfrei kontaktierenden Elektroden gegeben und durch einen p-Leitungstyp aufweisenden Bereich voneinander getrennt sind, bei der ausserdem die Elektrodenpaare der beiden Hallsonden derart relativ zueinander angeordnet sind, dass die in den beiden Hallsonden fliessenden Ströme senkrecht zueinander orientiert sind, dadurch gekennzeichnet, dass die Halbleiteroberfläche (26), an der die Hallsonden erzeugt sind, mit einer (100)-Ebene des Siliciumgitters zusammenfällt.

2. Anordnung nach Anspruch 1, dadurch gekennzeichnet, dass die beiden Hallsonden in einer epitaktischen Siliciumschicht erzeugt sind, die an der Oberfläche eines aus monokristallinem Silicium bestehenden und den entgegengesetzten Leitungstyp zur epitaktischen Schicht besitzenden Plättchens mit (100)-orientierter Oberfläche abgeschieden ist.

3. Anordnung nach Anspruch 1 und/oder 2, dadurch gekennzeichnet, dass die aufgrund eines gemeinsamen Magnetfelds an den beiden Hallsonden erhaltenen Ausgangssignale vor oder nach einer anschliessenden Signalverstärkung parallel zueinander geschaltet sind.

**Claims**

1. A monolithically integrated arrangement of two Hall probes which are produced on a common flat part of the surface of a doped monocrystalline silicon chip, wherein each of the two Hall probes is provided by a semiconductor region of n-conductivity type and two electrodes which contact the respective semiconductor region in a non-blocking manner, and wherein the two Hall probes are separated from one another by a region of p-conductivity type, and wherein, in addition, the electrode pairs of the two Hall probes are so arranged relative to one another that the currents flowing in the two Hall probes are orientated at right angles to one another, characterised in that the semiconductor surface (26) on which the Hall probes are produced, coincides with a (100)-plane of the silicon lattice.

2. An arrangement according to claim 1, characterised in that the two Hall probes are produced in a epitactic silicon layer which is deposited on the surface of a chip having a (100)-orientated surface and which consists of monocrystalline silicon and has the opposite conductivity type to the epitactic layer.

3. An arrangement according to claim 1 and/or claim 2, characterised in that the output signals which are received at the two Hall probes, by reason of a common magnetic field, are switched parallel to one another before or after a subsequent signal amplification.

**Revendications**

1. Agencement intégré monolithique de deux sondes à effet Hall qui sont produits sur une même partie de surface plane d'une plaquette de silicium monocristallin dopé, dans lequel chacune des deux sondes à effet Hall est fournie par une zone semiconductrice du type de productibilité n de même que par deux électrodes qui contactent de façon anti-bloquante la zone semiconductrice concernée, et sont séparées entre elles par une zone du type de conductibilité p, dans lequel, en outre, les paires d'électrodes des deux sondes à effet Hall sont disposées de telle façon l'une par rapport à l'autre que les courants qui passent par les deux sondes à effet Hall sont orienté perpendiculairement entre eux, caractérisé par le fait que la surface semiconductrice (26) sur laquelle sont produits les sondes à effet Hall coïncide avec un plan (100) du réseau de silicium.

2. Agencement selon la revendication 1, caractérisé par le fait que les deux sondes à effet Hall sont produites dans une couche de silicium épitaxiale qui est déposée sur la surface d'une plaquette, à surface d'orientation (100), constituée par du silicium monocristallin et possédant le type de conductibilité opposé à celui de la couche épitaxiale.

3. Agencement selon la revendication 1 et/ou 2, caractérisé par le fait que les signaux de sortie obtenus au niveau des deux sondes à effet Hall, en raison d'un champ magnétique commun, sont associée en parallèle entre eux, avant ou après une post-amplification desdits signaux.

**FIG 1**

**FIG 2**

**FIG 3**